# EUROPÄISCHE PATENTSCHRIFT

(11) **EP 4 096 097 B1**
(45) Veröffentlichungstag und Bekanntmachung des Hinweises auf die Patenterteilung: **06.08.2025**
(21) Anmeldenummer: 22169989.5
(22) Anmeldetag: 26.04.2022
(51) Int. Cl.: H03K 17/96

(54) **ANZEIGE- UND BEDIENEINRICHTUNG**
DISPLAY AND OPERATING DEVICE
DISPOSITIF D'AFFICHAGE ET DE COMMANDE

(30) Priorität: 26.05.2021 DE 102021205356
(43) Veröffentlichungstag der Anmeldung: 30.11.2022
(73) Patentinhaber: BSH Hausgeräte GmbH, 81739 München (DE)
(72) Erfinder: Hofmeister, Bernhard, 92331 Parsberg (DE); Wengert, Daniel, 89520 Heidenheim (DE)

(56) Entgegenhaltungen:
- DE-A1- 102014 111 640
- US-A1- 2003 210 537

## Beschreibung

Die Erfindung betrifft eine Anzeige- und Bedieneinrichtung zum Vornehmen von Einstellungen an einem Haushaltsgerät. Ferner ein Haushaltsgerät mit einer Anzeige und Bedieneinrichtung zum Vornehmen von Einstellungen an dem Haushaltsgerät.

In vielen elektrischen bzw. elektronischen Geräten, insbesondere auch in Haushaltsgeräten wie Herden, Kochfeldern, Mikrowellenöfen, Spülmaschinen, Waschmaschinen, Wäschetrocknern und dergleichen, werden häufig berührungsempfindliche Tastschalter bzw. Berührungs- und/oder Annäherungsschalter eingesetzt, die durch ein einfaches Berühren oder Annähern durch einen Benutzer bzw. einen Finger des Benutzers zum Beispiel einen bestimmten Schaltvorgang auslösen und/oder eine Geräteeinstellung ändern.

Die DE 10 2013 224 261 A1 offenbart einen kapazitiven Berührungs- und/oder Annäherungsschalter an einer Abdeckplatte, die auf einer dem Benutzer zugewandten Seite ein Berührungsfeld definiert und zumindest im Bereich des Berührungsfeldes elektrisch isolierend und wenigstens teilweise lichtdurchlässig ausgebildet ist, eine Trägerplatte, die auf einer dem Benutzer abgewandten Seite der Abdeckplatte mit einem Abstand zu dieser angeordnet ist; und ein Kopplungselement, das zwischen der Abdeckplatte und der Trägerplatte dem Berührungsfeld korrespondierend angeordnet ist und das mit einer elektrisch leitenden Kontaktfläche auf der Trägerplatte in Kontakt steht.

Die DE 10 259 297 A1 offenbart eine Einrichtung zur Beleuchtung von wenigstens einer auf einer transparenten Scheibe vorgesehenen Schaltfläche mittels wenigstens einer Lichtquelle, wobei hinter der Schaltfläche ein Berührungsschalter angeordnet ist, wobei die Lichtquelle beabstandet von der Schaltfläche angeordnet ist, die Lichtquelle die Scheibe oder einen an dieser angeordneten Lichtleiter bestrahlt und ihr Licht in der Scheibe oder dem Lichtleiter in Richtung der Schaltfläche geführt ist.

Es ist die Aufgabe der vorliegenden Erfindung, eine verbesserte Anzeige- und Bedieneinrichtung mit einem kapazitiven Bedienfeld zu schaffen, das einen einfachen Aufbau besitzt und zugleich eine Hinterleuchtung der Anzeige- und Bedieneinrichtung ermöglicht.

Diese Aufgabe wird gelöst durch eine Anzeige- und Bedieneinrichtung mit den Merkmalen des unabhängigen Anspruchs 1.

Vorteilhafte Weiterbildungen und Ausgestaltungen der Erfindung sind Gegenstand der abhängigen Ansprüche.

Ein Aspekt der vorliegenden Erfindung betrifft Anzeige- und Bedieneinrichtung zum Vornehmen von Einstellungen an einem Haushaltsgerät , aufweisend ein Trägergehäuse mit einer Anzeige- und Bedienblende mit einem Bedienfeld an einer dem Benutzer zugewandten Außenseite der Anzeige- und Bedienblende , eine Leiterplatte an einer dem Benutzer abgewandten Innenseite der Anzeige- und Bedienblende , und einen Lichtleiter an einer dem Benutzer abgewandten Innenseite der Anzeige- und Bedienblende mit einem flächigen Lichtleiterabschnitt mit einer randseitigen Lichteintrittsfläche , wobei die Leiterplatte eine äußere, der Anzeige- und Bedienblende zugewandte Hauptfläche aufweist, an der eine zum Hinterleuchten der Anzeige- und Bedienblende vorgesehene Lichtquelle und eine mit dem Bedienfeld korrespondierende elektrische Sensorfläche vorgesehen ist, wobei der flächige Lichtleiterabschnitt zwischen der elektrischen Sensorfläche und einer dem Benutzer abgewandten Innenseite der Anzeige- und Bedienblende gehalten ist, wobei die Lichtquelle außerhalb der elektrischen Sensorfläche auf der äußeren Hauptfläche der Leiterplatte angeordnet ist und eine Hauptabstrahlsachse der Lichtquelle auf die randseitige Lichteintrittsfläche gerichtet ist.

Erfindungsgemäß ist vorgesehen, dass im bestimmungsgemäßen Gebrauch der Anzeige-und Bedieneinrichtung der Lichtleiter mehrere horizontal nebeneinander angeordnete flächige Lichtleiterabschnitte aufweist, welche jeweils im Wesentlichen körperlich voneinander getrennt sind, wobei der Lichtleiter mehrere zu den flächigen Lichtleiterabschnitten korrespondierende Lichtquellen und elektrische Sensorflächen auf der Leiterplatte aufweist. Entsprechend der mehreren flächigen Lichtleiterabschnitte sind mehrere Lichtquellen und elektrischen Sensorflächen vorgesehen sowie entsprechend horizontal nebeneinander auf der Leiterplatte angeordnet. Entsprechend können dadurch mehrere Bedienfelder auf der Anzeige- und Bedienblende vorgesehen werden. Ferner können mehrere Bedienfelder oder Bedienfelderabschnitte für das Vornehmen von Einstellung für beispielsweise ein Kühlfach und ein Gefrierfach bei einem Haushaltskühlgerät vorgesehen werden. Da die obere Stirnleiste an einem Korpus eines Haushaltskühlgerätes eher schmal in Höhenrichtung ausgebildet ist, ist eine kettenförmige Anordnung der Bedienfelder bei Haushaltskühlgeräten besonders vorteilhaft.

Erfindungsgemäß ist vorgesehen, dass die mehreren flächigen Lichtleiterabschnitte jeweils in einer zu den flächigen Lichtleiterabschnitten korrespondierenden Vertiefung an der Innenseite der Anzeige- und Bedienblende angeordnet sind, wobei sich zwischen den geschlossenen Vertiefungen jeweils ein lichtundurchlässiger Wandvorsprung befindet, die dazu vorgesehen sind, eine Lichtvermengung von benachbart zueinander angeordneten flächigen Lichtleiterabschnitten zu vermeiden, vorzugweise sind die mehreren Lichtquellen ebenso in der Vertiefung angeordnet. Der mindestens eine Wandvorsprung ist dazu vorgesehen, einen Lichtwechsel in benachbart zueinander angeordneten flächigen Lichtleiterabschnitten zu vermeiden, Die Vertiefung ist vorzugsweise geschlossen oder taschenförmig ausgeführt und entspricht im Wesentlichen den Ausmaßen des flächigen Lichtleiterabschnitts. Die entsprechend mehreren Lichtquellen ragen vorzugsweise ebenfalls in die Vertiefung oder in einen Randausschnitt der Vertiefung. Vorzugsweise entsprechen die Umrisse der geschlossenen Vertiefung den Umrissen des Lichtleiters. Ferner entspricht die Dicke des flächigen Lichtleiters der Tiefe der Vertiefung. Der eine oder die mehreren Wandvorsprünge zwischen den Vertiefungen sind jeweils integral mit der Anzeige- und Bedienblende bzw. dem Tragekörper ausgeformt und ragen von der Innenseite der Anzeige- und Bedienblende ab.

In Tiefenrichtung der erfindungsgemäßen Anzeige- und Bedieneinrichtung ergibt sich ein verbesserter und schlankerer Aufbau der Anzeige- und Bedieneinrichtung, da die elektrische Sensorfläche und die Lichtquelle auf der äußeren Hauptfläche der Leiterplatte abseits voneinander angeordnet sind und der flächige Lichtleiterabschnitt zwischen der elektrischen Sensorfläche und der Lichtquelle gehalten ist. Ferner, da die elektrische Sensorfläche und der flächige Lichtleiterabschnitt flächig aufeinanderliegen, ist die Geometrie des Lichtleiters und der elektrischen Sensorfläche einfach und kostengünstig herstellbar. Ferner ist eine derartige Anzeige- und Bedieneinrichtung einfach und kostengünstig fertigbar, da durch das Halten des Lichtleiters zwischen der elektrischen Sensorfläche und der Anzeige- und Bedienblende keine zusätzlichen Befestigungen des Lichtleiters notwending sind.

Unter einem Trägergehäuse wird im Sinne der vorliegenden Erfindung ein Elektronikgehäuse verstanden, das dazu geeignet ist, elektronische Komponenten zu tragen und insbesondere zu umhüllen sowie für die elektrische Sicherheit zu sorgen. Dazu ist das Trägergehäuse vorzugsweise aus Kunststoff gebildet. Ferner kann das Trägergehäuse eine metallische Außenhülle aufweisen, um die Brandsicherheit zu gewährleisten.

Das Bedienfeld kann mehrere einzelne Bedienfelder aufweisen, welche nebeneinander angeordnet sind und als sog. LED-Kettenelektronik bekannt ist. Dabei handelt es sich typischerweise um längliche oder bandförmige Streifen mit in Längserstreckung in Reihe angeordneten berührungsempfindlichen Bedienfeldern (auch als "Touchfelder" oder "Direct Touch"-Bedienfelder bezeichnet). Die Bedienfelder sind vorzugweise als berührungsempfindliche Schichten oder Schichtstapel ausgebildet, die beispielsweise als kapazitive Näherungsschalter wirken. Anders als bei einem TFT-Display kann also bei einer LED-Kettenanzeigen jede Position nur mit einem bestimmten Anzeigefeld belegt werden. Als Träger einer LED-Kettenelektronik dient eine - steife oder biegsame - Leiterplatte oder Platine, auf der zusätzlich zu den berührungsempfindlichen Bedienfeldern und LEDs eine Schaltung oder Elektronik zur Auswertung der Bedienfelder auf Berührung, Ansteuerung der LEDs und ggf. Auslösen mindestens einer Aktion bei Berührung der Bedienfelder vorhanden ist.

Ein Haushaltsgerät im Sinne der vorliegenden Erfindung kann ein Herd, Kochfeld, Mikrowellenofen, Spülmaschine, Waschmaschine, Wäschetrockner, Kühlgerät und dergleichen sein.

Im Fall eines Bedienfeldes im Sinne der vorliegenden Erfindung bildet eine elektrische Sensorfläche zusammen mit zum Beispiel einem Finger eines Benutzers über ein Dielektrikum eine Kapazität aus, die entsprechend dem Betätigen des Bedienfelds der Anzeige- und Bedienblende variabel ist. Die Veränderung des Kapazitätswertes wirkt sich auf ein Ausgangssignal einer korrespondierenden Sensorschaltung aus, was von einer Auswerteelektronik als eine Betätigung des Bedienfelds interpretiert wird. Insbesondere entsteht beim Berühren des Bedienfelds durch einen Benutzer zur elektrischen Sensorfläche eine Kopplungskapazität, über die von der Sensorschaltung ein Ableitstrom zum Benutzer fließt, der von der Auswerteelektronik erkannt wird. Die Dicke des Dielektrikums kann 1 bis 4 mm betragen. Das Dielektrikum ist gemäß vorliegender Erfindung durch die Anzeige- und Bedienblende und den Lichtleiter, insbesondere den flächigen Lichtleiterabschnitt, gebildet.

Der Lichtleiter ist im Falle der vorliegenden Erfindung vorzugsweise aus einem nichtleitenden und lichtdurchlässigen Kunststoff gebildet. Beispielsweise aus Polymethylmethacrylat (PMMA) gebildet Der Lichtleiter ist derart konfiguriert, dass das randseitig über die Lichteintrittsfläche eingekoppelte Licht im Lichtleiter in verschiedene Bereiche verteilt bzw. gestreut wird. Entsprechend kann auch der flächige Lichtleiterabschnitt zum Hinterleuchten eines symbolischen Bedienfeldes dienen. Da der Lichtleiter vorzugsweise nichtleitend ausgebildet ist, kann dieser kostengünstig gefertigt werden.

Unter der elektrischen Sensorfläche wird im Allgemeinen eine metallische Fläche bzw. Metall-Pad verstanden. Insbesondere entsteht durch das Berühren des Bedienfeldes durch einen Benutzer zur elektrischen Sensorfläche eine Kopplungskapazität, über die von einer kapazitiven Sensorschaltung ein Ableitstrom zum Benutzer fließt, der von einer Auswerteelektronik erkannt wird.

Unter einer randseitigen Lichteintrittsfläche wird eine Fläche des flächigen Lichtleiterabschnitts verstanden, welche der Lichtquelle zugewandt ist und vorzugsweise poliert ausgeführt ist. Durch die Polierung der Fläche kann eine ungewollte Brechung oder Reflektion der Lichtstrahlen gemindert oder sogar verhindert werden.

Die Lichtquelle ist vorzugsweise unmittelbar benachbart außerhalb der elektrischen Sensorfläche angeordnet. Beim bestimmungsgemäßen Gebrauch der Anzeige- und Bedieneinrichtung befindet sich die Lichtquelle vorzugsweise oberhalb der elektrischen Sensorfläche und koppelt das Licht in die Lichteintrittsfläche des flächigen Lichtleiters von oben ein.

Unter einer Leiterplatte wird im Sinne der vorliegenden Erfindung vorzugsweise eine bedruckte Leiterplatte bzw. PCB ("printed circuit board") angesehen, auf der vorzugsweise SMD-Bauelemente ("Surface-mounted device") angeordnet sind.

Nach einer Ausgestaltung ist vorgesehen, dass dass der Lichtleiter einen linienförmigen Lichtleiterabschnitt in Verlängerung des flächigen Lichtleiterabschnitts aufweist, der an einem zur randseitigen Lichteintrittsfläche gegenüberliegenden Ende des flächigen Lichtleiterabschnitts vorgesehen ist, wobei insbesondere der linienförmige Lichtleiterabschnitt relativ zum flächigen Lichtleiterabschnitt in einem Winkel von 60 bis 120 Grad angeordnet ist und von dem flächigen Lichtleiterabschnitt in Richtung der Anzeige- und Bedienblende absteht. Vorzugsweise erstreckt sich der linienförmige Lichtleiterabschnitt horizontal unterbrechungsfrei in Breitenrichtung der Anzeige- und Bedienblende bei bestimmungsgemäßen Gebrauch der Anzeige- und Bedieneinrichtung. Im bestimmungsgemäßen Gebrauch der Anzeige- und Bedieneinrichtung befindet sich die Lichteintrittsfläche oberhalb der elektrischen Sensorfläche und der linienförmige Lichtleiterabschnitt unterhalb der elektrischen Sensorfläche, um eine Indikation der Einstellung auf dem Bedienfeld an den Benutzer zu geben.

Nach einer Ausgestaltung ist vorgesehen, dass im bestimmungsgemäßen Gebrauch der Anzeige- und Bedieneinrichtung die Lichtquelle oberhalb der elektrischen Sensorfläche und der linienförmige Lichtleiterabschnitt unterhalb der elektrischen Sensorfläche angeordnet ist.. Dadurch ist der Vorteil erreicht, dass die Lichtquelle und der linienförmige Lichtleiterabschnitt an gegenüberliegenden Seiten der elektrischen Sensorfläche angeordnet sind, wodurch die Platzaufteilung der Komponenten in der Anzeige- und Bedieneinrichtung verbessert ist.

Nach einer Ausgestaltung ist vorgesehen, dass zwischen dem flächigen Lichtleiterabschnitt und dem linienförmigen Lichtleiterabschnitt ein Reflektor vorgesehen ist, wobei der Reflektor als eine in Richtung der Anzeige- und Bedienblende anfallende Wand des Lichtleiters vorgesehen ist. Dadurch ist der Vorteil erreicht, dass die Lichtstrahlen durch den flächigen Lichtleiterabschnitt in Richtung der Anzeige- und Bedienblende umgelenkt und emittiert werden. Der Reflektor ist vorzugweise derart geneigt und gerichtet, dass die durch den flächigen Lichtleiterabschnitt durchtretenden Lichtstrahlen in Richtung der Lichtaustrittsfläche des linienförmigen Lichtleiterabschnitts über dessen gesamte Breite gleichmäßig umgelenkt werden. Dies hat den Vorteil, dass die Leuchtstärke im linienförmigen Lichtleiterabschnitt gleichmäßig und ausreichend ist. Im betriebsgemäßen Gebrauch der Anzeige- und Bedieneinrichtung ist die Neigung in Richtung der Anzeige- und Bedienblende geneigt und der Neigungswinkel beträgt 35 bis 55 Grad, vorzugsweise 45 Grad relativ zu einer Flächennormalen auf der äußeren Hauptfläche des flächigen Lichtleiterabschnitts.

Nach einer Ausgestaltung ist vorgesehen, dass im bestimmungsgemäßen Gebrauch der Anzeige- und Bedieneinrichtung der linienförmige Lichtleiterabschnitt eine Lichtaustrittsfläche aufweist, die unterhalb des Bedienfelds der Anzeige- und Bedienblende vorgesehen ist, insbesondere der linienförmige Lichtleiterabschnitt hinter oder in einem länglichen Durchbruch der Anzeige- und Bedienblende angeordnet ist, wobei der längliche Durchbruch mit einem Linienfeld auf der Anzeige- und Bedienblende korrespondiert und der linienförmige Lichtleiterabschnitt dazu vorgesehen ist, das Linienfeld durch den länglichen Durchbruch entsprechend der Einstellung am Bedienfeld zu hinterleuchten. Dadurch ergibt sich der Vorteil, dass dem Benutzer nach Betätigung eines Bedienfeldes direkt durch ein entsprechendes Lichtfeedback in Form eines beleuchteten Unterstrichs signalisiert wird, dass die Auswahl registriert und übernommen wurde. Die Lichtaustrittsfläche ist vorzugweise eine Randfläche des linienförmigen Lichtleiterabschnitts, welche in Richtung der Anzeige- und Bedienblende gewandt ist. Vorzugsweise ist die Lichtaustrittsfläche des linienförmigen Lichtleiterabschnitts glatt poliert ausgeführt, so dass die Streuung der austretenden Lichtstrahlen möglichst gering gehalten wird. Die Lichtaustrittsfläche ist vorzugsweise in einem Durchbruch der Anzeige-und Bedienblende vorgesehen.

Nach einer Ausgestaltung ist vorgesehen, dass sich im bestimmungsgemäßen Gebrauch der Anzeige- und Bedieneinrichtung der linienförmige Lichtleiterabschnitt horizontal über mehrere flächige Lichtleiterabschnitte erstreckt und körperlich unterbrechungsfrei ausgebildet ist. Dadurch ergibt sich der Vorteil, dass der Lichtleiter einfach und kostengünstig herstellbar ist, da weniger filigrane Elemente des Lichtleiters zu fertigen sind. Durch eine vorgelagerte bedruckte Folie auf der Anzeige- und Bedienblende und entsprechendem Versatz zwischen den transluzenten oder semitransparenten Bereichen der bedruckten Folie, welche den Unterstrich der Symbole darstellen und mit Teilabschnitten des linienförmigen Lichtleiterabschnitts korrespondieren, ist eine Lichtvermengung oder Lichtwechsel in benachbarte Liniensegmente des Linienfelds vermieden oder verdeckt.

Nach einer Ausgestaltung ist vorgesehen, dass dass die Lichtquelle eine radial auskoppelnde lichtemittierende Diode (LED) ist, wobei die Hauptlichtaustrittsachse im Wesentlichen parallel zur äußeren Hauptfläche der Leiterplatte vorgesehen ist. Vorzugsweise im bestimmungsgemäßen Gebrauch der Anzeige- und Bedieneinrichtung das Licht nach unten auskoppelt. Dadurch ergibt sich der Vorteil, dass durch die Verwendung einer lichtemittierenden Diode die Anzeige- und Bedienungseinrichtung energetischer betreibbar ist. Ferner lässt sich eine lichtemittierende Diode einfacher in SMD-Bauweise auf einer Leiterplatte verbauen und benötigt wenig Bauraum. Durch die Lichteinkopplung von oben in den flächigen Lichtleiterabschnitt kann das Licht entlang der elektrischen Sensorfläche gestreut und in den linienförmigen Lichtleiterabschnitt im Wesentlichen senkrecht zur Anzeige- und Bedienblende ausgekoppelt werden. Die Lichtquelle ist vorzugweise als "side looker" - LED ausgeführt, welche das Licht radial auskoppelt und die entlang Hauptabstrahlachse in 90° von der Befestigungsachse der LED hat.

Nach einer Ausgestaltung ist vorgesehen, dass im bestimmungsgemäßen Gebrauch der Anzeige- und Bedieneinrichtung der flächige Lichtleiterabschnitt hinter oder in einem flächenhaften Durchbruch der Anzeige- und Bedienblende angeordnet ist, wobei der flächenhafte Durchbruch mit dem Bedienfeld korrespondiert und der flächige Lichtleiterabschnitt dazu vorgesehen ist, das Bedienfeld durch den flächenhaften Durchbruch zu hinterleuchten. Vorzugsweise ist der Durchbruch symbolhaft ausgeführt, so dass dem Benutzer neben einer Lichtindikation eine Information zum eingestellten Kriterium, wie zum Beispiel die Fächertemperatur, Super-Funktion oder Ein/Aus-Funktion, mitgeteilt wird.

Nach einer Ausgestaltung ist vorgesehen, dass der flächige Lichtleiterabschnitt bei senkrechter Draufsicht auf eine der Hauptflächen einen aufweitenden Lichtleiterabschnitt aufweist, der die randseitige Lichteintrittsfläche aufweist. Die Lichtquelle ist räumlich beabstandet von der Lichteintrittsfläche und deren Hauptabstrahlachse liegt vorzugsweise senkrecht auf der Lichteintrittsfläche des flächigen Lichtleiterabschnitts. Dies hat den Vorteil, dass die emittierten Lichtstrahlen der Lichtquelle im Wesentlichen vollständig über die Lichteintrittsfläche in den flächigen Lichtleiterabschnitt gekoppelt werden und eine Expansion innerhalb des flächigen Lichtleiterabschnitts möglich ist.

Nach einer Ausgestaltung ist vorgesehen, dass die Leiterplatte an der von der Anzeige-und Bedienblende abgewandten Hauptfläche mit weiteren elektrischen Bauteilen bestückt ist, welche eine Schaltung zur Auswertung des Bedienfelds auf Berührung, Ansteuerung der Lichtquelle und Auslösen mindestens einer Aktion bei Berührung der Bedienfelder ausbilden. Dies hat den Vorteil, dass im bestimmungsgemäßen Gebrauch der Anzeige-und Bedieneinrichtung die äußere Hauptfläche der Leiterplatte im Wesentlichen frei von elektrischen Bauelementen ausgebildet ist und der Lichtweg des emittierten Lichts der Lichtquelle störungsfrei und unverschattet ist.

Nach einer Ausgestaltung ist vorgesehen, dass die Anzeige- und Bedienblende mit einer bedruckten Folie ausgestattet ist, die mindestens einen transluzenten Bereich aufweist, der mit mindestens einem linienförmigen und/oder flächenhaften Durchbruch korrespondiert. Die Anordnung der transluzenten Bereiche auf der bedruckten Folie sind derart gewählt, dass das emittierte Licht des flächigen Lichtleiterabschnitts und/oder des linienförmigen Lichtleiterabschnitts durch die transluzenten Bereich austreten kann. Der transluzente Bereich kann ferner semitransparent ausgebildet sein. Die Bedienfelder sind beispielsweise mit einer Maske versehen, um jedem Bedienfeld eine fest vorgegebene Leuchtinformation zuzuordnen, z.B. in Form von Buchstaben, Zahlen, Symbolen usw. Die anderen Bereiche der bedruckten Folie sind mit einer opaquen Beschichtung versehen und entsprechend lichtundurchlässig ausgeführt. Die bedruckte Folie ist vorzugsweise auf die Anzeige- und Bedienblende aufgeklebt.

Nach einer Ausgestaltung ist vorgesehen, dass die Leiterplatte an der Innenseite der Anzeige- und Bedienblende mit dem Trägergehäuse über Befestigungsbolzen heißverstemmt ist. Um Kunststoffträger mit beispielsweise Leiterplatten oder Metallkomponenten zu verbinden, werden unter Anwendung von Kraft und Wärme Kunststoffdome geschmolzen und umgeformt, so dass eine dauerhafte formschlüssige, kraftschlüssige und teilweise darüber hinaus stoffschlüssige Verbindung vorliegt. Der Befestigungsbolzen kann aus thermoplastischen Kunststoff wie zum Beispiel PA, PBT, PC, PE, POM und PP hergestellt sein. Neben dem Fixieren der Bauteile zueinander ermöglicht diese Verbindungstechnik zudem die Übertragung von Kräften zwischen der Leiterplatte und der Anzeige- und Bedienblende, so dass der Lichtleiter zwischen der Innenseite der Anzeige- und Bedienblende und Leiterplatte in der Vertiefung eingeklemmt werden kann.

Nach einer Ausgestaltung ist vorgesehen, dass das Trägergehäuse einen von der Anzeige- und Bedienblende abstehenden Aufnahmeschacht aufweist, in dem die Leiterplatte und der Lichtleiter verbaut sind. Der Aufnahmeschacht dient dazu, die elektronischen Komponenten auf der Leiterplatte zu schützen. Ferner kann der Aufnahmeschacht die elektrische Sicherheit oder Brandsicherheit gewährleisten. Der Aufnahmeschacht ist vorzugsweise aus Kunststoff gebildet. Für die Brandsicherheit kann der Aufnahmeschacht eine metallische Außenhaut aufweisen.

Einen weiteren Aspekt der Erfindung betrifft ein Haushaltsgerät, insbesondere Haushaltskältegerät, mit einer Anzeige- und Bedieneinrichtung zum Vornehmen von Einstellungen an dem Haushaltsgerät.

Mit Angaben "oben", "unten", "vorne", "hinten, "horizontal", "vertikal", "Tiefenrichtung", "Breitenrichtung", "Höhenrichtung" etc. sind die bei bestimmungsgemäßen Gebrauch und bestimmungsgemäßem Anordnen des Geräts und bei einem dann insbesondere vor dem Gerät stehenden und in Richtung des Geräts blickenden Beobachter gegebenen Positionen und Orientierungen angegeben.

Weitere Merkmale der Erfindung ergeben sich aus den Ansprüchen, den Figuren und der Figurenbeschreibung.

Ausführungsbeispiele der Erfindung sind exemplarisch in den beigefügten schematischen Zeichnungen dargestellt. Es zeigen:
- Fig. 1: in einer perspektivischen Darstellung ein Haushaltsgerät mit einer schematisch gezeigten Anzeige- und Bedieneinrichtung,
- Fig. 2: in einer perspektivischen Explosionsdarstellung der Anzeige- und Bedieneinrichtung,
- Fig. 3: in einer perspektivischen Darstellung einen Teilausschnitt einer Innenseite eines Trägergehäuses der Anzeige- und Bedieneinrichtung nach Figur 2.
- Fig. 4: in einer perspektivischen Darstellung der Teilausschnitt des Trägergehäuses mit einem Lichtleiter der Anzeige- und Bedieneinrichtung nach Figur 2,
- Fig. 5: eine perspektivische Darstellung einer Frontseite der Anzeige- und Bedienblende der Anzeige- und Bedieneinrichtung nach Figur 2,
- Fig. 6: eine seitliche Ansicht der Leiterplatte mit einem Lichtleiter und einer Lichtquelle der Anzeige- und Bedieneinrichtung nach Figur 2 ohne das Trägergehäuse,
- Fig. 7: eine frontseitige Ansicht der Leiterplatte mit der Lichtquelle und dem Lichtleiter nach Figur 6,
- Fig. 8: eine Schnittdarstellung der zusammengebauten Anzeige- und Bedieneinrichtung nach Figur 2,
- Fig. 9: eine perspektivische Ansicht der Leiterplatte der Anzeige- und Bedieneinrichtung nach Figur 2 mit mehreren elektrischen Sensorflächen und Lichtquellen,
- Fig. 10: eine frontseitige Ansicht der Anzeige- und Bedieneinrichtung in einer ersten Ausführungsform,
- Fig. 11: eine frontseitige Ansicht der Anzeige- und Bedieneinrichtung in einer zweiten Ausführungsform, und
- Fig. 12: eine frontseitige Ansicht der Anzeige- und Bedieneinrichtung in einer dritten Ausführungsform.

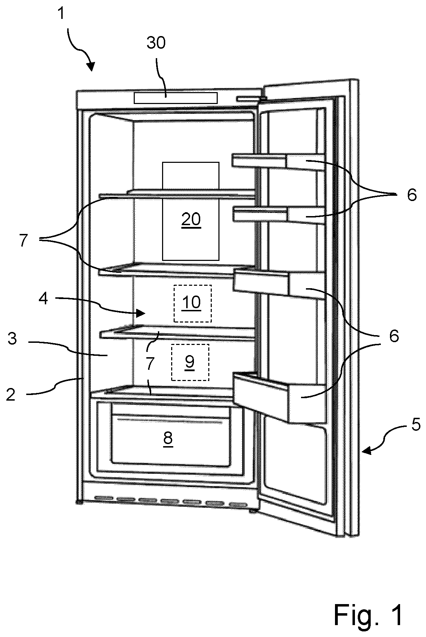

Die Fig. 1 zeigt in einer perspektivischen Darstellung beispielhaft ein Haushaltsgerät 1, insbesondere Haushaltskältegerät, mit einer schematisch gezeigten Anzeige- und Bedieneinrichtung 30, das einen mit einem Isolierschaum wärmeisolierten Korpus 2 mit einem Innenbehälter 3 umfasst. Der Innenbehälter 3 begrenzt einen zum Lagern von nicht dargestellten Lebensmitteln vorgesehenen kühlbaren Innenraum 4.

Das Haushaltskältegerät 1 umfasst ferner ein Türblatt 5, welches insbesondere bezüglich einer vertikal verlaufenden Achse schwenkbar am Korpus 2 gelagert ist. Bei geöffnetem Türblatt 5 ist der kühlbare Innenraum 4 zugänglich.

An der in Richtung kühlbaren Innenraum 4 gerichteten Seite des Türblatts 5 sind im Falle des vorliegenden Ausführungsbeispiels mehrere Türabsteller 6 zum Lagern von Lebensmitteln angeordnet. Im kühlbaren Innenraum 4 sind insbesondere mehrere Fachböden 7 zum Lagern von Lebensmitteln angeordnet und im unteren Bereich des kühlbaren Innenraums 4 ist insbesondere eine Schublade 8 angeordnet, in der ebenfalls Lebensmittel gelagert werden können. Die nach oben gerichtete Öffnung der Schublade 8 wird von dem untersten Fachboden 7 abgedeckt.

Das Haushaltskältegerät 1 umfasst eine, dem Fachmann im Prinzip bekannte Kältevorrichtung 9 vorzugsweise in Form eines Kältemittelkreislaufs zum Kühlen des kühlbaren Innenraums 4.

Das Haushaltskältegerät 1 umfasst im Falle des vorliegenden Ausführungsbeispiels eine elektronische Steuervorrichtung 10, die die Kältevorrichtung 9, insbesondere den Verdichter des Kältemittelkreislaufs in für den Fachmann in allgemein bekannter Weise derart anzusteuern, dass der kühlbare Innenraum 4 zumindest in etwa eine vorgegebene oder vorgebbare Soll-Temperatur aufweist. Die elektronische Steuervorrichtung 10 ist vorzugsweise derart eingerichtet, dass sie die Temperatur des kühlbaren Innenraums 4 regelt. Um gegebenenfalls die Ist-Temperatur des kühlbaren Innenraums 4 zu erhalten, kann das Haushaltskältegerät 1 wenigstens einen nicht näher dargestellten und mit der elektronischen Steuervorrichtung 10 verbundenen Temperatursensor aufweisen.

Ferner umfasst das Haushaltskältegerät 1 wenigstens eine Innenraumbeleuchtung 20, die vorgesehen ist, den kühlbaren Innenraum 4 bei geöffnetem Türblatt 5 zu beleuchten. Die Innenraumbeleuchtung 20 ist im Falle des vorliegenden Ausführungsbeispiels am Innenbehälter 3 befestigt. Die Innenraumbeleuchtung 20 kann an einer Seitenwand 3a oder Rückwand 3b des Innenbehälters 3 angeordnet sein.

Ferner umfasst das Haushaltskältegerät 1 die horizontal entlang der oberen Stirnleiste des Korpus 2 erstreckende Anzeige- und Bedieneinrichtung 30 zum Vornehmen bzw. Ändern von Einstellungen an dem beispielhaften Haushaltskühlgerät 1.

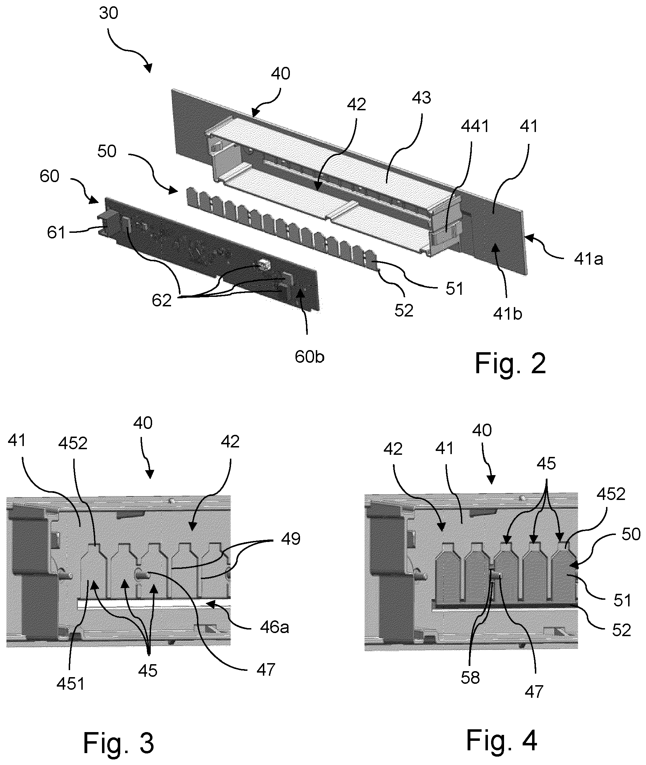

In Figur 2 ist die erfindungsgemäße Anzeige- und Bedieneinrichtung 30 in einer Explosionsdarstellung gezeigt. Die Anzeige-und Bedieneinrichtung 30 weist ein Trägergehäuse 40 mit einer Anzeige- und Bedienblende 41 auf, an der ein von der Innenseite 41b oder von der dem Benutzer abgewandten Seite der Anzeige- und Bedienblende 41 herauskragender Aufnahmeschacht 42 vorgesehen ist. Ferner befindet sich an einer Außenseite 41a bzw. an einer dem Benutzer zugewandten Seite eine in der Darstellung nicht einsehbare Anzeige- und Bedienfläche an der Anzeige- und Bedienblende. Der Aufnahmeschacht 42 umschließt mit Schachtwänden 43 einen Bauraum, in dem ein Lichtleiter 50, bestehend aus einem flächigen Lichtleiterabschnitt 51 und einem linienförmigen Lichtleiterabschnitt 52, und eine Leiterplatte 60, umfassend elektrische Bauelemente 62 und einen elektrischen Anschluss 61 auf einer, der Anzeige-und Bedienblende 41 abgewandten inneren Hauptfläche 60b der Leiterplatte 60 bei bestimmungsgemäßen Gebrauch der Anzeige- und Bedieneinrichtung 30, vorgesehen ist. Der flächige Lichtleiterabschnitt 51 umfasst mehrere nebeneinander angeordnete flächige Lichtleiterabschnitte 51. Der linienförmigen Lichtleiterabschnitt 52 erstreckt sich unterhalb der mehreren flächigen Lichtleiterabschnitt 51 und verbindet die mehreren flächigen Lichtleiterabschnitte 51 miteinander. Dazu ist der linienförmigen Lichtleiterabschnitt 52 in horizontaler Richtung bei bestimmungsgemäßen Gebrauch der Anzeige- und Bedieneinrichtung 30 körperlich unterbrechungsfrei ausgeführt. Ferner umfasst der Aufnahmeschacht 42 am Randbereich eine oder mehrere Schnapp-Rast Verbindungen 441, welche mit entsprechenden Gegenrastelementen in einer Vertiefung des hier nicht dargestellten Haushaltsgeräts 1, insbesondere Quertraverse, verschnappen.

In Figur 3 ist in einer perspektivischen Darstellung ein Teilausschnitt des Trägergehäuses 40 nach Figur 2 dargestellt. In dem Bauraum des Aufnahmeschachts 42 sind mehrere Vertiefungen 45 vorgesehen, in dem der Lichtleiter 50 untergebracht ist. Die Vertiefungen 45 sind vorzugsweise geschlossen ausgeführt bzw. bilden ein vertieftes Feld aus und umfassen einen ersten Vertiefungsabschnitt 451, in dem der in der Darstellung nicht gezeigte flächige Lichtleiterabschnitt 51 im zusammengebauten Zustand der Anzeige- und Bedieneinrichtung 30 angeordnet ist, und einen zweiten Vertiefungsabschnitt 452, in dem eine in der Darstellung nicht gezeigte Lichtquelle im zusammengebauten Zustand der Anzeige- und Bedieneinrichtung 30 vorgesehen ist. Der erste Vertiefungsabschnitt 451 entspricht im Wesentlichen den Ausmaßen des hier nicht dargestellten flächigen Lichtleiterabschnitts 51. Die Vertiefungen 45 befinden sich an einer Innenseite 41b bzw. an einer dem Benutzer abgewandten Innenseite 41b der Anzeige- und Bedienblende 41 in dem Aufnahmeschacht 42. Zwischen den Vertiefungen 45 erstreckt sich jeweils ein lichtundurchlässiger Wandvorsprung 47, der dazu vorgesehen ist, einen Lichtwechsel von benachbart zueinander angeordneten flächigen Lichtleiterabschnitten 51 zu vermeiden. Der Wandvorsprung 47 ist integral mit dem Trägergehäuse 40 ausgeformt und ragt von der Innenseite 41b der Anzeige- und Bedienblende 41 ab. Ferner ist in Figur 3 ein Befestigungsbolzen 48 dargestellt, über welchen der in der Darstellung nicht gezeigte Lichtleiter 50 gestülpt wird und mit der hier nicht dargestellten Leiterplatte 60 heißverstemmt wird. Dadurch wird der hier nicht gezeigte Lichtleiter 50 in die Vertiefung 45 gedrückt und durch Heißverstemmen über den Befestigungsbolzen 48 darin gehalten. Ferner befindet sich direkt unterhalb der Vertiefung 45 ein länglicher Durchbruch 46a, in den ein in der Darstellung nicht gezeigter linienförmiger Lichtleiterabschnitt 52 angeordnet ist. Der länglicher Durchbruch 46a erstreckt horizontal entlang der mehreren Vertiefungen 45.

In Figur 4 ist in einer perspektivischen Darstellung der Teilausschnitt des Trägergehäuses 40 nach Figur 2 mit dem Lichtleiter 50 im montierten Zustand dargestellt. Über Figur 3 hinausgehend zeigt die Figur 4, dass der Lichtleiter 50 mit seinem flächigen Lichtleiterabschnitt 51 in der Vertiefung 45 nach Figur 3 angeordnet ist und mit seinem linienförmigen Lichtleiterabschnitt 52 in dem Durchbruch 46a angeordnet ist. Ferner umfasst der Lichtleiter 50 zwischen zwei der flächigen Lichtleiterabschnitte 51 verbindende Stege 58, die einen Zwischenraum ausbilden, durch den der mit der Anzeige- und Bedienblende 41 integral ausgeformte Befestigungsbolzen 48 hindurchragt. Die Stege 58 sind integral mit dem Lichtleiter 50 ausgeformt. Ferner ist ein zweiter Vertiefungsabschnitt 452 in der Vertiefung oberhalb des Lichtleiters 50 vorgesehen, in den eine in der Darstellung nicht gezeigte Lichtquelle 63 im montierten Zustand der Anzeige-und Bedieneinrichtung 30 ragen kann.

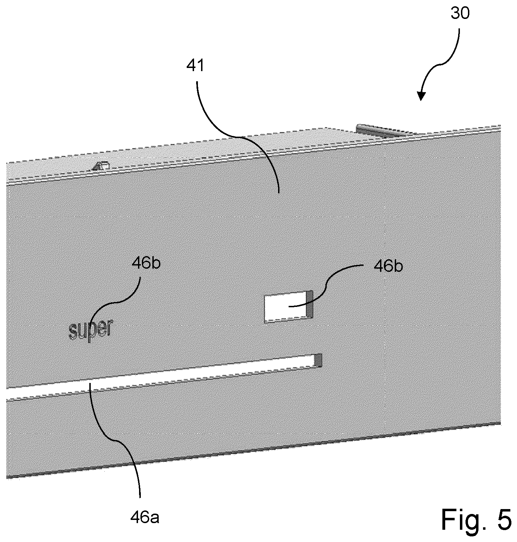

In Figur 5 ist in einer perspektivischen Darstellung eine Frontseite der Anzeige- und Bedienblende 41 der Anzeige- und Bedieneinrichtung 30 nach Figur 2 gezeigt. Die Frontseite der Anzeige- und Bedienblende 41 ist im verbauten Zustand der Anzeige-Bedieneinrichtung 30 einem Benutzer des Haushaltsgeräts 1 zugewandt. In der Frontwand der Anzeige- Bedienblende 41 sind Durchbrüche 46a, 46b vorgesehen. Der Durchbruch 46a, in dem der in der Darstellung nicht gezeigte linienförmige Lichtleiterabschnitt 52 im zusammengebauten Zustand der Anzeige- Bedieneinrichtung 30 vorgesehen ist, ist länglich ausgebildet und erstreckt horizontal bzw. in Längsrichtung der Anzeige- und Bedieneinrichtung 30. Um eine einfache Fertigung der Anzeige- und Bedieneinrichtung 30 zu ermöglichen, ist der Durchbruch 46a in horizontaler Richtung unterbrechungsfrei bzw. ohne Zwischenwände ausgebildet. Ferner sind in der Anzeige-und Bedienblende 41 oberhalb des linienförmigen Durchbruchs 46a mehrere Durchbrüche 46b vorgesehen. Einer der Durchbrüche 46b ist symbolfrei und als rechtwinkliger Ausschnitt gezeigt. Ein weiterer Durchbruch 46b ist symbolhaft dargestellt bzw. symbolisiert die "Super-Funktion" bei beispielsweise einem Haushaltskältegerät. Entsprechend der Auswahl an der Anzeige- und Bedieneinrichtung wird der Durchbruch 46a durch den in Figur 5 nicht dargestellten flächigen Lichtleiterabschnitt 51 hinterleuchtet oder ausgeleuchtet und der linienförmige Durchbruch 46a bzw. Teilabschnitte davon durch den in Figur 5 nicht dargestellten linienförmigen Lichtleiterabschnitt 52 hinterleuchtet oder ausgeleuchtet.

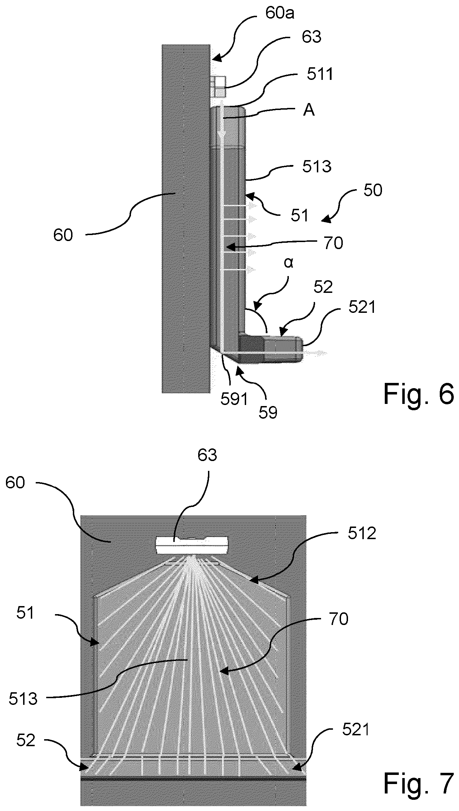

In Figur 6 ist in einer seitlichen Ansicht eine Leiterplatte 60 mit einem Lichtleiter 50 und einer Lichtquelle 63 der Anzeige- und Bedieneinrichtung 30 nach Figur 2 ohne das Trägergehäuse 40 gezeigt. Der Lichtleiter 50 bzw. der flächige Lichtleiterabschnitt 51 liegt mit seiner Rückseite plan an einer äußeren bzw. einer dem Benutzer zugewandten Hauptfläche 60a der Leiterplatte 60 im zusammengebaut Zustand der Anzeige- und Bedieneinrichtung 30 an. An der äußeren Hauptfläche 60a der Leiterplatte 60 ist zudem eine Lichtquelle 63 vorgesehen, welche vorzugsweise über Lötpads auf der Leiterplatte 60 bestückt ist. Die Lichtquelle 63 ist im bestimmungsgemäßen Gebrauch der Anzeige-und Bedieneinrichtung 30 oberhalb des Lichtleiters 50 bzw. flächigen Lichtleiterabschnitt 51 angeordnet. Die Lichtquelle 63 koppelt das Licht radial oder seitlich entlang der äußeren Hauptfläche 60a der Leiterplatte 60 aus, wobei eine Hauptabstrahlachse A der Lichtquelle 63 auf eine randseitige Lichteintrittsfläche 511 des flächigen Lichtleiterabschnitt 51 gerichtet ist. Die Lichtquelle 63 koppelt das Licht entsprechend randseitig bzw. an einer Schmalseite in den Lichtleiter 50 ein. Die Lichteintrittsfläche 511 ist dazu vorzugsweise glatt und poliert ausgeführt, sodass Lichtreflexion an der Lichteintrittsfläche 511 verhindert oder zumindest vermindert werden. Die emittierten Lichtstrahlen 70 von der Lichtquelle 63, insbesondere lichtemittierenden Diode bzw. "side looker LED" , werden über die Lichteintrittsfläche 511 in den Lichtleiter 50 eingekoppelt und leuchten den flächigen Lichtleiterabschnitt 51 sowie den an einem der Lichtquelle 63 gegenüberliegenden Ende des flächigen Lichtleiterabschnitt 51 angeordneten linienförmigen Lichtleiterabschnitt 52 aus. Im bestimmungsgemäßen Gebrauch der Anzeige- und Bedieneinrichtung 30 zeigt die Hauptabstrahlachse A nach unten in Richtung des Lichtleiter 50.

Ferner umfasst der flächige Lichtleiterabschnitt 51 einen flächigen Lichtaustrittsbereich 513, welcher einen in Figur 6 nicht dargestellten flächigen Durchbruch 46b im betriebsgemäßen Gebrauch der Anzeige- und Bedieneinrichtung 30 hinterleuchtet oder ausleuchtet. Der linienförmige Lichtleiterabschnitt 52 ist relativ zum flächigen Lichtleiterabschnitt 51 in einem Winkel α von 90 Grad angeordnet. Der linienförmige Lichtleiterabschnitt 52 ragt im bestimmungsgemäßen Gebrauch der Anzeige- und Bedieneinrichtung 30 senkrecht von dem flächigen Lichtleiterabschnitt 51 in Richtung der in der Darstellung nicht gezeigten Anzeige und Bedienblende 41 ab. Der linienförmige Lichtleiterabschnitt 52 weist einen linienförmigen Lichtaustrittsbereich 521 auf, welcher einen in Figur 5 gezeigten, in Figur 6 aber nicht dargestellten länglichen Durchbruch 46b hinterleuchtet oder ausleuchtet. Zwischen dem flächigen Lichtleiterabschnitt 51 und dem in einem Winkel α von 90 Grad abstehenden linienförmigen Lichtleiterabschnitt 52 ist ein Reflektor 59, insbesondere eine Reflektorfläche 591, vorgesehen, welcher dazu geeignet ist, die vom flächigen Lichtleiterabschnitt 51 kommenden Lichtstrahlen 70 in den linienförmigen Lichtleiterabschnitt 52 umzulenken.

In Figur 7 ist eine frontseitige Ansicht der Leiterplatte 60 mit der Lichtquelle 63 und dem Lichtleiter 50 nach Figur 6 gezeigt. In der Darstellung ist näher ersichtlich, dass die Lichtquelle 63 eine seitliche oder radiale Hauptabstrahlachse A aufweist, die auf eine randseitige Lichteintrittsfläche 511 des Lichtleiters 50, insbesondere flächigen Lichtleiterabschnitt 51, gerichtet ist. Die von der Lichtquelle 63 ausgesandten Lichtstrahlen 70 werden in die randseitige Lichteintrittsfläche 511 eingekoppelt und in einem aufweitenden bzw. trapezförmigen Lichtleiterabschnitt 512 des flächigen Lichtleiterabschnitts 51 in Breitenrichtung des flächigen Lichtleiterabschnitts 51 gestreut bzw. expandiert. Dadurch ist erreicht, dass die Lichteintrittsfläche 511 möglichst das gesamte emittierte Licht der Lichtquelle 63 einfängt und durch den aufweitenden Lichtleiterabschnitt 512 möglichst gleichmäßig über die Breite des flächigen Lichtleiterabschnitts 51 verstreut und entsprechend eine gleichmäßige Ausleuchtung des flächigen Lichtleiterabschnitts 51 sowie des linienförmigen Lichtleiterabschnitts 52 möglich ist. Der flächige Lichtleiterabschnitt 51 koppelt die Lichtstrahlen 70 über einen flächigen Lichtaustrittsbereich 513 und der linienförmige Lichtleiter koppelt die Lichtstrahlen 70 entsprechend über den linienförmigen Lichtaustrittsbereich 521 aus.

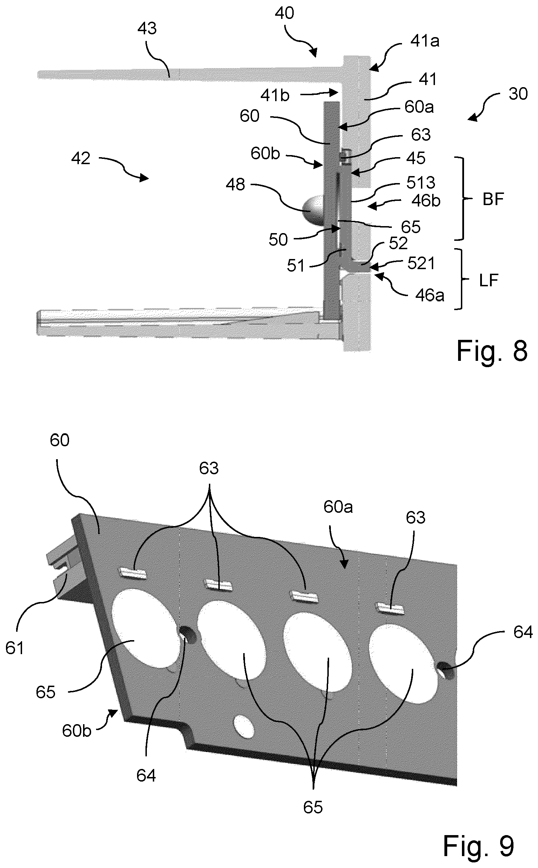

In Figur 8 ist eine Schnittdarstellung der zusammengebauten Anzeige- und Bedieneinrichtung 30 nach Figur 2 gezeigt. In der Darstellung ist das Trägergehäuse 40 mit dem Aufnahmeschacht 42 gezeigt, in dem der Lichtleiter 50 und die Leiterplatte 60 montiert sind. Die Leiterplatte 60 ist über den Befestigungsbolzen 48 mit dem Trägergehäuse 40 bzw. der Anzeige- und Bedienblende 41 heißverstemmt. Zwischen der Anzeige- und Bedienblende 41 und der Leiterplatte 60 ist der Lichtleiter 50 gehalten bzw. eingefasst. Der Lichtleiter 50 und die auf der äußeren Hauptfläche 60a der Leiterplatte 60 angeordnete Lichtquelle 63 sind in der Vertiefung 45 an der Innenseite 41b der Anzeige-und Bedienblende 41 angeordnet. An der Außenseite 41a sind Durchbrüche 46a, 46b vorgesehen, wobei im bestimmungsgemäßen Gebrauch der Anzeige- und Bedieneinrichtung 30 der untere Durchbruch 46a mit dem linienförmigen Lichtleiterabschnitt 52 korrespondiert und der obere Durchbruch 46b mit dem flächigen Lichtleiterabschnitt 51 korrespondiert. Der linienförmige Lichtleiterabschnitt 52 ist in der Darstellung in dem Durchbruch 46a angeordnet, um den Durchbruch 46a des Linienfelds LF der Anzeige- und Bedieneinrichtung 30 über den linienförmigen Lichtaustrittsbereich 521 zu hinterleuchten oder auszuleuchten, und der flächige Lichtleiterabschnitt 51 ist hinter dem Durchbruch 46b angeordnet, um den Durchbruch 46b des Bedienfelds BF der Anzeige- und Bedieneinrichtung 30 über den flächigen Lichtaustrittsbereich 513 zu hinterleuchten oder auszuleuchten. Der linienförmige Lichtleiterabschnitt 52 kann natürlich auch hinter dem linienförmigen Durchbruch 46a und der flächige Lichtleiterabschnitt 51 kann in dem Durchbruch 46b angeordnet sein. Die Anzeige- und Bedieneinrichtung 30 ist demnach derart konfiguriert, dass es entweder das Bedienfeld BF oder das Linienfeld LF ausleuchten kann oder beide zugleich.

Ferner ist auf der äußeren Hauptfläche 60a der Leiterplatte 60 ein elektrisches Sensorfeld 65 angeordnet, über welches die Annäherung oder Berührung mit dem Finger eines Benutzers detektiert werden kann. Das Sensorfeld 65 ist metallisch bzw. leitend ausgeführt und hat eine kreisförmige Fläche oder ist als kreisförmiges Lötpad ausgebildet. Das Sensorfeld 65 ist elektrisch mit einer auf der inneren Hauptfläche 60b der Leiterplatte 60 angeordneten, in der Darstellung nicht gezeigten Auswerteelektronik verbunden, dazu überbrückt die Sensorfläche 65 den Kontakt von der äußeren Hauptfläche 60a auf die innere Hauptfläche 60b der Leiterplatte 60.

In Figur 9 ist eine perspektivische Ansicht der Leiterplatte 60 mit mehreren elektrischen Sensorflächen 65 und Lichtquellen 63, insbesondere LED's, der Anzeige- und Bedieneinrichtung 30 nach Figur 2 gezeigt. Die mehreren elektrischen Sensorflächen 65 und Lichtquellen 63 sind sind im bestimmungsgemäßen Gebrauch der Anzeige- und Bedieneinrichtung 30 an einer äußeren, der Anzeige- und Bedienblende 41 zugewandten Hauptfläche 60a der Leiterplatte 60 angeordnet erstrecken sich in horizontaler Richtung nebeneinander. Entsprechend ist eine der mehreren Lichtquellen 63 im bestimmungsgemäßen Gebrauch der Anzeige- und Bedieneinrichtung 30 jeweils oberhalb einer der mehreren Sensorflächen 65 angeordnet. Die elektrischen Sensorflächen 65 auf der äußeren Hauptfläche 60a sind auf die innere Hauptlfäche 60b der Leiterplatte 60 elektrisch durchgebrückt. Ferner sind Durchbrüche 64 gezeigt, durch welche jeweils ein Befestigungsbolzen 48 bei der Montage hindurchgeführt werden kann. Ferner ist an der den Sensorflächen 65 gegenüberliegenden Hauptfläche 60b der Leiterplatte 60 ein elektrischer Anschluss 61 der Leiterplatte 60 vorgesehen. Dieser elektrische Anschluss 61 ist zum Anschließen von elektrischen Versorgungsleitungen und Datenleitungen an die Leiterplatte 60 vorgesehen.

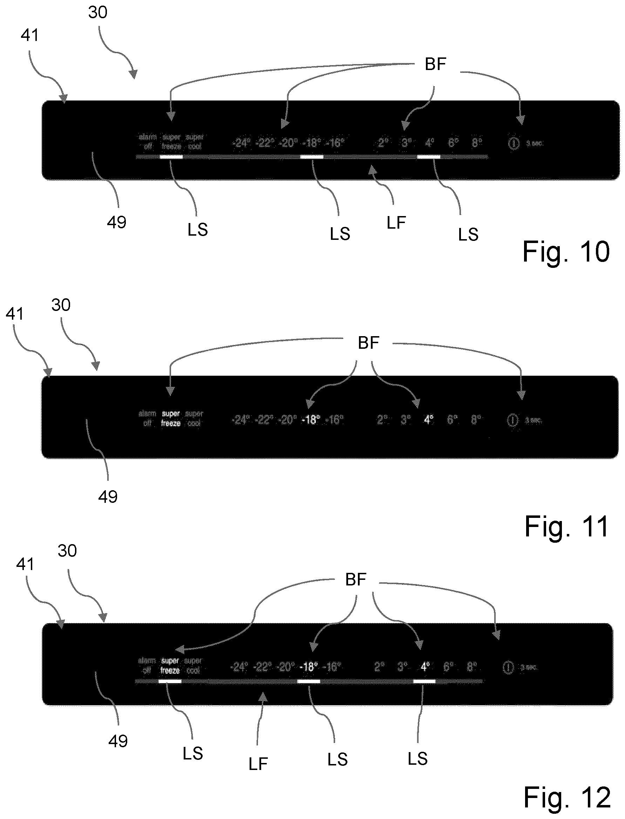

In Figur 10 ist eine frontseitige Ansicht der Anzeige- und Bedieneinrichtung 30 in einer ersten Ausführungsform gezeigt. In der ersten Ausführungsform sind einzelne Segmente eines Linienfelds LF hinterleuchtet. Das Linienfeld LF ist unterhalb des Bedienfelds BF vorgesehen. Das Bedienfeld BF besteht aus horizontal nebeneinander angeordneten Symbolen, welche in der Ausführungsform nicht hinterleuchtet sind. Der Benutzer kann auf dem Bedienfeld BF mit dem Finger die Einstellungen am Haushaltsgerät durch Annäherung oder Berührung der Symbole verändern. Beispielhaft kann im Bedienfeld BF die Temperatur von einem Gefrier- oder Kühlbereich verändert werden oder bestimmte Funktionen aktiviert werden. Für die Einstellung der Temperatur in einem Kühlfach oder Gefrierfach sind Bedienfeldketten vorgesehen, die nur eine Einzelauswahl in der entsprechenden Bedienfeldkette zulassen. In der Darstellung signalisieren die Liniensegmente am Linienfeld LF unterhalb des Bedienfelds BF, welche Einstellungen am Haushaltsgerät aktiviert sind. In dem Fall ist die Superfunktion, die Temperatur von -18 °C im Gefrierbereich sowie die Temperatur von 4 °C im Kühlbereich eingestellt. Die Anzeige-und Bedienblende 41 der Anzeige- und Bedieneinrichtung 30 ist entsprechend mit einer opaque bzw. lichtundurchlässig bedruckten Folie 49 ausgestattet, welche im Bereich des hier verdeckten Durchbruchs 46a transluzent oder semitransparent ausgebildet ist. In dem Fall hinterleuchter nur der hier nicht gezeigte linienförmige Lichtleiterabschnitt 52 die Anzeige- und Bedienblende 41 bzw. das Leuchtfeld LF. Die transluzenten oder semitransparenten Bereiche der bedruckten Folie befinden sich entsprechend in dem Ausführungsbeispiel im Bereich des Linienfeld LF. Die einzelnen Liniensegmente LS im Linienfeld LF sind vorzugsweise durch eine opaque Bedruckung der Folie 49 unterbrochen, sodass sichtbare Lichtvermengung zwischen den Liniensegmenten LS vermieden werden.

In Figur 11 ist eine frontseitige Ansicht der Anzeige- und Bedieneinrichtung 30 in einer zweiten Ausführungsform gezeigt. Im Unterschied zur Figur 10 sind in der zweiten Ausführungsform nur das Bedienfeld BF bzw. die einzelnen Bedienfelder BF hinterleuchtet. Entsprechend ist die bedruckte Folie im Bereich des Bedienfeld BF transluzent oder semitransparent ausgebildet und die Hinterleuchtung des Bedienfelds BF findet nur durch hier nicht gezeigten flächigen Lichtleiterabschnitt statt. Eine Hinterleuchtung des Linienfelds LF bzw. der Liniensegmente LS entfällt. Das Linienfeld LF entfällt in dem Ausführungsbeispiel. In der zweiten Ausführungsform ist demnach die Optik und das Erscheinungsbild der Anzeige- und Bedieneinrichtung 30 bei lediglich Änderung der Bedruckung auf der Folie 49 veränderbar, aufwändige Änderungen des konstruktiven Aufbaus der Anzeige- und Bedieneinrichtung 30 bleiben somit aus, wodurch mit einfachen Mitteln ein neues Erscheinungsbild und eine neue Darstellungsform der Anzeige- und Bedieneinrichtung 30 realisiert ist.

In Figur 12 ist eine weitere frontseitige Ansicht der Anzeige- und Bedieneinrichtung 30 in einer dritten Ausführungsform gezeigt. Im Unterschied zur Figur 10 und Figur 11 sind in der Darstellung sowohl das Bedienfeld BF wie auch das Linienfeld LF hinterleuchtet und bildet eine Indikation der Einstellungen an der Anzeige- und Bedieneinrichtung. In der dritten Ausführungsform ist somit eine weitere optische Darstellungsmöglichkeit einer Anzeige- und Bedieneinrichtung 30 geschaffen, ohne Änderung des konstruktiven Aufbaus der Anzeige- und Bedieneinrichtung 30. Entsprechend ist der konstruktive Aufbau der Anzeige- und Bedieneinrichtung 30 dazu geeignet, mit einfachen Mitteln verschiedene optische Darstellungen anzunehmen, ohne den konstruktiven Aufbau der Anzeige- und Bedieneinrichtung 30 zu ändern und somit nur durch Änderung der Bedruckung auf der wechselbaren bzw. bedruckten Folie 49 zu realisieren.

### BEZUGSZEICHENLISTE

- 1: Haushaltskältegerät
- 2: wärmeisolierter Korpus
- 3: Innenbehälter
- 4: Innenraum
- 5: Türblatt
- 6: Türabsteller
- 7: Fachböden
- 8: Schublade
- 9: Kältevorrichtung
- 10: elektronische Steuervorrichtung
- 20: Innenraumbeleuchtung
- 30: Anzeige- und Bedieneinrichtung
- 40: Tragegehäuse
- 41: Anzeige- und Bedienblende
- 41a: Außenseite
- 41b: Innenseite
- 42: Aufnahmeschacht
- 43: Schachtwand
- 44: Schnapp-Rast Verbindung
- 45: Vertiefung
- 451: Vertiefungsabschnitt
- 452: Vertiefungsabschnitt
- 46a: Durchbruch
- 46b: Durchbruch
- 47: Rippe
- 48: Befestigungsbolzen
- 49: bedruckte Folie
- BF: Bedienfeld
- AF: Auswahlfeld
- LF: Linienfeld
- LS: Liniensegmente
- 50: Lichtleiter
- 51: flächiger Lichtleiterabschnitt
- 511: Lichteintrittsfläche
- 512: aufweitender Lichtleiterabschnitt
- 513: flächiger Lichtaustrittsbereich
- 52: linienförmiger Lichtleiterabschnitt
- 521: linienförmiger Lichtaustrittsbereich
- 58: Steg
- 59: Reflektor
- 591: Reflektorfläche
- 60: Leiterplatte
- 60a: äußere Hauptseite
- 60b: innere Hauptseite
- 61: elektrischer Anschluß
- 62: elektrische Bauelemente
- 63: Lichtquelle
- 64: Durchbruch
- 65: elektrische Sensorfläche
- 70: Lichtstrahl
- A: Hauptabstrahlachse

## Patentansprüche

1. Anzeige- und Bedieneinrichtung (30) zum Vornehmen von Einstellungen an einem Haushaltsgerät (1), aufweisend ein Trägergehäuse (40) mit einer Anzeige- und Bedienblende (41) mit einem Bedienfeld (BF) an einer dem Benutzer zugewandten Außenseite (41a) der Anzeige- und Bedienblende (41), eine Leiterplatte (60) an einer dem Benutzer abgewandten Innenseite (41b) der Anzeige- und Bedienblende (41), und einen Lichtleiter (50) an einer dem Benutzer abgewandten Innenseite (41b) der Anzeige- und Bedienblende (41) mit einem flächigen Lichtleiterabschnitt (51) mit einer randseitigen Lichteintrittsfläche (511), wobei die Leiterplatte (60) eine äußere, der Anzeige- und Bedienblende (41) zugewandte Hauptfläche (60a) aufweist, an der eine zum Hinterleuchten der Anzeige- und Bedienblende (41) vorgesehene Lichtquelle (63) und eine mit dem Bedienfeld (BF) korrespondierende elektrische Sensorfläche (65) vorgesehen ist, wobei der flächige Lichtleiterabschnitt (51) zwischen der elektrischen Sensorfläche (65) und einer dem Benutzer abgewandten Innenseite (41b) der Anzeige- und Bedienblende (41) gehalten ist, die Lichtquelle (63) außerhalb der elektrischen Sensorfläche (65) auf der äußeren Hauptfläche (60a) der Leiterplatte (60) angeordnet ist und eine Hauptabstrahlsachse (A) der Lichtquelle (63) auf die randseitige Lichteintrittsfläche (511) gerichtet ist, **dadurch gekennzeichnet, dass** im bestimmungsgemäßen Gebrauch der Anzeige- und Bedieneinrichtung (30) der Lichtleiter (50) mehrere horizontal nebeneinander angeordnete flächige Lichtleiterabschnitte (51) aufweist, welche jeweils im Wesentlichen körperlich voneinander getrennt sind, wobei der Lichtleiter (51) mehrere zu den flächigen Lichtleiterabschnitten (51) korrespondierende Lichtquellen (63) und elektrische Sensorflächen (65) auf der Leiterplatte (60) aufweist, wobei die mehreren flächigen Lichtleiterabschnitte (51) jeweils in einer zu den flächigen Lichtleiterabschnitten korrespondierenden Vertiefung (45) an der Innenseite (411) der Anzeige- und Bedienblende (41) angeordnet sind, wobei sich zwischen den Vertiefungen (45) jeweils ein lichtundurchlässiger Wandvorsprung (49) befindet.

2. Anzeige- und Bedieneinrichtung (30) nach Anspruch 1, **dadurch gekennzeichnet, dass** der Lichtleiter (50) einen linienförmigen Lichtleiterabschnitt (52) in Verlängerung des flächigen Lichtleiterabschnitts (51) aufweist, der an einem zur randseitigen Lichteintrittsfläche (511) gegenüberliegenden Ende des flächigen Lichtleiterabschnitts (51) vorgesehen ist, wobei insbesondere der linienförmige Lichtleiterabschnitt (52) relativ zum flächigen Lichtleiterabschnitt (51) in einem Winkel (α) von 60 bis 120 Grad angeordnet ist und von dem flächigen Lichtleiterabschnitt (51) in Richtung der Anzeige- und Bedienblende (41) absteht.

3. Anzeige- und Bedieneinrichtung (30) nach Anspruch 2, **dadurch gekennzeichnet, dass** im bestimmungsgemäßen Gebrauch der Anzeige- und Bedieneinrichtung (30) die Lichtquelle (63) oberhalb der elektrischen Sensorfläche (65) und der linienförmige Lichtleiterabschnitt (52) unterhalb der elektrischen Sensorfläche (65) angeordnet ist.

4. Anzeige- und Bedieneinrichtung (30) nach Anspruch 2 oder 3, **dadurch gekennzeichnet, dass** zwischen dem flächigen Lichtleiterabschnitt (51) und dem linienförmigen Lichtleiterabschnitt (52) ein Reflektor (59) vorgesehen ist, wobei der Reflektor (59) als eine in Richtung der Anzeige- und Bedienblende (41) abfallende Wand des Lichtleiters (50) vorgesehen ist.

5. Anzeige- und Bedieneinrichtung (30) nach einem der Ansprüche 2 bis 4, **dadurch gekennzeichnet, dass** im bestimmungsgemäßen Gebrauch der Anzeige- und Bedieneinrichtung (30) der linienförmige Lichtleiterabschnitt (52) eine Lichtaustrittsfläche (521) aufweist, die unterhalb des Bedienfelds (BF) der Anzeige-und Bedienblende (41) vorgesehen ist, insbesondere der linienförmige Lichtleiterabschnitt (52) hinter oder in einem länglichen Durchbruch (46a) der Anzeige- und Bedienblende (41) angeordnet ist, wobei der längliche Durchbruch (46a) mit einem Linienfeld (LF) auf der Anzeige- und Bedienblende (41) korrespondiert und der linienförmige Lichtleiterabschnitt (52) dazu vorgesehen ist, das Linienfeld (LF) durch den länglichen Durchbruch (46a) entsprechend der Einstellung am Bedienfeld (BF) zu hinterleuchten.

6. Anzeige- und Bedieneinrichtung (30) nach einem der Ansprüche 2 bis 5, **dadurch gekennzeichnet, dass** sich im bestimmungsgemäßen Gebrauch der Anzeige- und Bedieneinrichtung (30) der linienförmige Lichtleiterabschnitt (52) horizontal über mehrere flächige Lichtleiterabschnitte (51) erstreckt und körperlich unterbrechungsfrei ausgebildet ist.

7. Anzeige- und Bedieneinrichtung (30) nach einem der vorhergehenden Ansprüche, **dadurch gekennzeichnet, dass** die Lichtquelle (63) eine radial auskoppelnde lichtemittierende Diode ist, wobei die Hauptabstrahlachse (A) im Wesentlichen parallel zur äußeren Hauptfläche (60a) der Leiterplatte (60) vorgesehen ist.

8. Anzeige- und Bedieneinrichtung (30) nach einem der vorhergehenden Ansprüche, **dadurch gekennzeichnet, dass** im bestimmungsgemäßen Gebrauch der Anzeige- und Bedieneinrichtung (30) der flächige Lichtleiterabschnitt (51) hinter oder in einem flächenhaften Durchbruch (46b) der Anzeige- und Bedienblende (41) angeordnet ist, wobei der flächenhaften Durchbruch (46b) mit dem Bedienfeld (BF) korrespondiert und der flächige Lichtleiterabschnitt (51) dazu vorgesehen ist, das Bedienfeld (BF) durch den flächenhaften Durchbruch (46b) zu hinterleuchten.

9. Anzeige- und Bedieneinrichtung (30) nach einem der vorhergehenden Ansprüche, **dadurch gekennzeichnet, dass** der flächige Lichtleiterabschnitt (51) bei senkrechter Draufsicht auf eine der Hauptflächen (51a, 51b) einen aufweitenden Lichtleiterabschnitt (512) aufweist, der die randseitige Lichteintrittsfläche (511) aufweist.

10. Anzeige- und Bedieneinrichtung (30) nach einem der vorhergehenden Ansprüche, **dadurch gekennzeichnet, dass** die mehreren Lichtquellen (63) ebenso in die Vertiefung (45) ragen.

11. Anzeige- und Bedieneinrichtung (30) nach einem der vorhergehenden Ansprüche, **dadurch gekennzeichnet, dass** die Leiterplatte (60) an der von der Anzeige- und Bedienblende (41) abgewandten Hauptfläche (60b) mit weiteren elektrischen Bauteilen (62) bestückt ist, welche eine Schaltung zur Auswertung des Bedienfelds (BF) auf Berührung, Ansteuerung der Lichtquelle (63) und Auslösen mindestens einer Aktion bei Berührung der Bedienfelder ausbilden.

12. Anzeige- und Bedieneinrichtung (30) nach Anspruch 5 oder 8, **dadurch gekennzeichnet, dass** die Anzeige- und Bedienblende (41) mit einer bedruckten Folie (49) ausgestattet ist, die mindestens einen transluzenten Bereich aufweist, der mit mindestens einem linienförmigen und/oder flächenhaften Durchbruch (46a, 46b) korrespondiert.

13. Anzeige- und Bedieneinrichtung (30) nach einem der vorhergehenden Ansprüche, **dadurch gekennzeichnet, dass** die Leiterplatte (60) an der Innenseite (41b) der Anzeige- und Bedienblende (41) mit dem Trägergehäuse (40) über Befestigungsbolzen (48) heißverstemmt ist.

14. Haushaltsgerät, insbesondere Haushaltskältegerät (1), mit einer Anzeige- und Bedieneinrichtung (30) zum Vornehmen von Einstellungen an dem Haushaltsgerät (1) nach einem der vorhergehenden Ansprüche.

## Claims

1. Display and operator control facility (30) for making adjustments to a household appliance (1), having a carrier housing (40) with a display and operator control panel (41) with an operator control field (BF) on an outer side (41a), which faces towards the user, of the display and operator control panel (41), a circuit board (60) on an inner side (41b), which faces away from the user, of the display and operator control panel (41), and a waveguide (50) on an inner side (41b), which faces away from the user, of the display and operator control panel (41) with a planar waveguide section (51) with an edge-side light entry area (511), wherein the circuit board (60) has an outer main area (60a), which faces towards the display and operator control panel (41) and on which a light source (63) provided for backlighting the display and operator control panel (41) and an electrical sensor area (65) corresponding to the operator control field (BF) are provided, wherein the planar waveguide section (51) is held between the electrical sensor area (65) and an inner side (41b), which faces away from the user, of the display and operator control panel (41), the light source (63) is arranged outside of the electrical sensor area (65) on the outer main area (60a) of the circuit board (60) and a main emission axis (A) of the light source (63) is directed at the edge-side light entry area (511), **characterised in that**, during intended use of the display and operator control facility (30), the waveguide (50) has multiple planar waveguide sections (51), which are arranged adjacent to one another horizontally and are in each case substantially separated from one another physically, wherein the waveguide (51) has multiple light sources (63) corresponding to the planar waveguide sections (51) and electrical sensor areas (65) on the circuit board (60), wherein the multiple planar waveguide sections (51) in each case are arranged in a depression (45), which corresponds to the planar waveguide sections, on the inner side (411) of the display and operator control panel (41), wherein a light-impermeable wall protrusion (49) is located between the depressions (45) in each case.

2. Display and operator control facility (30) according to claim 1, **characterised in that** the waveguide (50) has a line-shaped waveguide section (52) in extension of the planar waveguide section (51), which is provided on an end of the planar waveguide section (51) that lies opposite the edge-side light entry area (511), wherein in particular the line-shaped waveguide section (52) is arranged at an angle (α) of 60 to 120 degrees relative to the planar waveguide section (51) and protrudes from the planar waveguide section (51) in the direction of the display and operator control panel (41).

3. Display and operator control facility (30) according to claim 2, **characterised in that**, during intended use of the display and operator control facility (30), the light source (63) is arranged above the electrical sensor area (65) and the line-shaped waveguide section (52) is arranged below the electrical sensor area (65).

4. Display and operator control facility (30) according to claim 2 or 3, **characterised in that** a reflector (59) is provided between the planar waveguide section (51) and the line-shaped waveguide section (52), wherein the reflector (59) is provided as a wall of the waveguide (50) which slopes down in the direction of the display and operator control panel (41).

5. Display and operator control facility (30) according to one of claims 2 to 4, **characterised in that**, during intended use of the display and operator control facility (30), the line-shaped waveguide section (52) has a light exit area (521), which is provided below the operator control field (BF) of the display and operator control panel (41), in particular the line-shaped waveguide section (52) is arranged behind or in an elongated perforation (46a) of the display and operator control panel (41), wherein the elongated perforation (46a) corresponds to a line field (LF) on the display and operator control panel (41) and the line-shaped waveguide section (52) is provided for backlighting the line field (LF) through the elongated perforation (46a) according to the adjustment to the operator control field (BF).

6. Display and operator control facility (30) according to one of claims 2 to 5, **characterised in that**, during intended use of the display and operator control facility (30), the line-shaped waveguide section (52) extends horizontally over multiple planar waveguide sections (51) and is embodied without physical interruptions.

7. Display and operator control facility (30) according to one of the preceding claims, **characterised in that** the light source (63) is a radially decoupling light-emitting diode, wherein the main emission axis (A) is provided substantially in parallel with the outer main area (60a) of the circuit board (60).

8. Display and operator control facility (30) according to one of the preceding claims, **characterised in that**, during intended use of the display and operator control facility (30), the planar waveguide section (51) is arranged behind or in a wide-area perforation (46b) of the display and operator control panel (41), wherein the wide-area perforation (46b) corresponds to the operator control field (BF) and the planar waveguide section (51) is provided for backlighting the operator control field (BF) through the wide-area perforation (46b).

9. Display and operator control facility (30) according to one of the preceding claims, **characterised in that** the planar waveguide section (51), in a perpendicular top view of one of the main areas (51a, 51b), has a widening waveguide section (512) that has the edge-side light entry area (511).

10. Display and operator control facility (30) according to one of the preceding claims, **characterised in that** the multiple light sources (63) likewise protrude into the depression (45).

11. Display and operator control facility (30) according to one of the preceding claims, **characterised in that** the circuit board (60), on the main area (60b) facing away from the display and operator control panel (41), is populated with further electrical components (62) that embody a circuit for evaluating the operator control field (BF) for contact, actuation of the light source (63) and triggering of at least one action on contact of the operator control fields.

12. Display and operator control facility (30) according to claim 5 or 8, **characterised in that** the display and operator control panel (41) is equipped with a printed film (49), which has at least one translucent region that corresponds to at least one line-shaped and/or wide-area perforation (46a, 46b).

13. Display and operator control facility (30) according to one of the preceding claims, **characterised in that** the circuit board (60) is heat-staked to the carrier housing (40) via fastening bolts (48) on the inner side (41b) of the display and operator control panel (41).

14. Household appliance, in particular household refrigeration appliance (1), with a display and operator control facility (30) for making adjustments to the household appliance (1) according to one of the preceding claims.

## Revendications

1. Dispositif d'affichage et de commande (30) pour effectuer des réglages sur un appareil ménager (1), présentant un boîtier de support (40) avec un bandeau d'affichage et de commande (41) avec un champ de commande (BF) sur un côté extérieur (41a) tourné vers l'utilisateur du bandeau d'affichage et de commande (41), une carte de circuit imprimé (60) sur un côté intérieur (41b) éloigné de l'utilisateur du bandeau d'affichage et de commande (41), et un conduit de lumière (50) sur un côté intérieur (41b) éloigné de l'utilisateur du bandeau d'affichage et de commande (41) avec une section de conduit de lumière plane (51) avec une surface d'entrée de lumière (511) côté bord, dans lequel la carte de circuit imprimé (60) présente une surface principale (60a) extérieure, dirigée vers le bandeau d'affichage et de commande (41), sur laquelle est prévue une source lumineuse (63) prévue pour le rétro-éclairage du bandeau d'affichage et de commande (41) et une surface de capteurs (65) électrique correspondant au champ de commande (BF), dans lequel la section de conduit de lumière plane (51) est maintenue entre la surface de capteurs (65) électrique et un côté intérieur (41b) du bandeau d'affichage et de commande (41) éloigné de l'utilisateur, la source lumineuse (63) est disposée en dehors de la surface de capteurs (65) électrique sur la surface principale extérieure (60a) de la carte de circuit imprimé (60) et un axe de rayonnement principal (A) de la source lumineuse (63) est dirigé sur la surface d'entrée de lumière (511) côté bord, **caractérisé en ce qu'**en utilisation conforme du dispositif d'affichage et de commande (30), le conduit de lumière (50) présente plusieurs sections de conduit de lumière planes (51) disposées horizontalement les unes à côté des autres, lesquelles sont respectivement séparées pour l'essentiel physiquement les unes des autres, dans lequel le conduit de lumière (51) présente plusieurs sources lumineuses (63) correspondant aux sections de conduit de lumière planes (51) et des surfaces de capteur (65) électriques sur la carte de circuit imprimé (60), dans lequel les plusieurs sections de conduit de lumière planes (51) sont respectivement disposées dans un renfoncement (45) correspondant aux sections de conduit de lumière planes sur le côté intérieur (411) du bandeau d'affichage et de commande (41), dans lequel une saillie de paroi opaque (49) se trouve respectivement entre les renfoncements (45).

2. Dispositif d'affichage et de commande (30) selon la revendication 1, **caractérisé en ce que** le conduit de lumière (50) présente une section de conduit de lumière linéaire (52) dans le prolongement de la section de conduit de lumière plane (51), qui est prévue en une extrémité de la section de conduit de lumière plane (51) opposée à la surface d'entrée de lumière (511) côté bord, dans lequel la section de conduit de lumière linéaire (52) est en particulier disposée selon un angle (α) de 60 à 120 degrés par rapport à la section de conduit de lumière plane (51) et faisant saillie de la section de conduit de lumière plane (51) en direction du bandeau d'affichage et de commande (41).

3. Dispositif d'affichage et de commande (30) selon la revendication 2, **caractérisé en ce qu'**en utilisation conforme du dispositif d'affichage et de commande (30), la source lumineuse (63) est disposée au-dessus de la surface de capteurs (65) électrique et la section de conduit de lumière linéaire (52) est disposée en dessous de la surface de capteurs (65) électrique.

4. Dispositif d'affichage et de commande (30) selon la revendication 2 ou 3, **caractérisé en ce qu'**un réflecteur (59) est prévu entre la section de conduit de lumière plane (51) et la section de conduit de lumière linéaire (52), dans lequel le réflecteur (59) est prévu sous la forme d'une paroi du conduit de lumière (50) en pente vers le bandeau d'affichage et de commande (41).

5. Dispositif d'affichage et de commande (30) selon l'une des revendications 2 à 4, **caractérisé en ce qu'**en utilisation conforme du dispositif d'affichage et de commande (30), la section de conduit de lumière linéaire (52) présente une surface de sortie de lumière (521) qui est prévue en dessous du champ de commande (BF) du bandeau d'affichage et de commande (41), en particulier la section de conduit de lumière linéaire (52) est disposée derrière ou dans une ouverture oblongue (46a) du bandeau d'affichage et de commande (41), dans lequel l'ouverture oblongue (46a) correspond à un champ de lignes (LF) sur le bandeau d'affichage et de commande (41) et la section de conduit de lumière linéaire (52) est prévue pour rétro-éclairer le champ de lignes (LF) à travers l'ouverture oblongue (46a) en fonction du réglage sur le champ de commande (BF).

6. Dispositif d'affichage et de commande (30) selon l'une des revendications 2 à 5, **caractérisé en ce qu'**en utilisation conforme du dispositif d'affichage et de commande (30), la section de conduit de lumière linéaire (52) s'étend est formée horizontalement sur plusieurs sections de conduit de lumière planes (51) et est réalisée physiquement sans interruption.

7. Dispositif d'affichage et de commande (30) selon l'une des revendications précédentes, **caractérisé en ce que** la source lumineuse (63) est une diode électroluminescente à découplage radial, dans lequel l'axe de rayonnement principal (A) est prévu essentiellement parallèle à la surface principale extérieure (60a) de la carte de circuit imprimé (60).

8. Dispositif d'affichage et de commande (30) selon l'une des revendications précédentes, **caractérisé en ce qu'**en utilisation conforme du dispositif d'affichage et de commande (30), la section de conduit de lumière plane (51) est disposée derrière ou dans une ouverture extensive (46b) du bandeau d'affichage et de commande (41), dans lequel l'ouverture extensive (46b) correspond au champ de commande (BF) et la section de conduit de lumière plane (51) est prévue pour rétro-éclairer le champ de commande (BF) à travers l'ouverture extensive (46b).

9. Dispositif d'affichage et de commande (30) selon l'une des revendications précédentes, **caractérisé en ce que** la section de conduit de lumière plane (51) présente, en vue du dessus à la perpendiculaire sur l'une des surfaces principales (51a, 51b), une section de conduit de lumière (512) s'élargissant, qui présente la surface d'entrée de lumière (511) côté bord.

10. Dispositif d'affichage et de commande (30) selon l'une des revendications précédentes, **caractérisé en ce que** les plusieurs sources lumineuses (63) font également saillie dans le renfoncement (45).

11. Dispositif d'affichage et de commande (30) selon l'une des revendications précédentes, **caractérisé en ce que** la carte de circuit imprimé (60) est équipée, sur la surface principale (60b) éloignée du bandeau d'affichage et de commande (41), de composants électriques supplémentaires (62) qui forment un circuit pour l'évaluation du champ de commande (BF) à l'effleurement, à la commande de la source lumineuse (63) et au déclenchement d'au moins une action en présence d'un effleurement des champs de commande.

12. Dispositif d'affichage et de commande (30) selon la revendication 5 ou 8, **caractérisé en ce que** le bandeau d'affichage et de commande (41) est équipé d'un film imprimé (49) qui présente au moins une zone translucide qui correspond à au moins une ouverture (46a, 46b) linéaire et/ou extensive.

13. Dispositif d'affichage et de commande (30) selon l'une des revendications précédentes, **caractérisé en ce que** la carte de circuit imprimé (60) est matée à chaud sur le côté intérieur (41b) du bandeau d'affichage et de commande (41) avec le boîtier de support (40), par le biais de boulons de fixation (48).

14. Appareil ménager, en particulier appareil frigorifique ménager (1), avec un dispositif d'affichage et de commande (30) pour effectuer des réglages sur l'appareil ménager (1) selon l'une des revendications précédentes.
